# FASCICULE DE BREVET EUROPEEN

(11) **EP 3 159 707 B1**
(45) Date de publication et mention de la délivrance du brevet: **30.12.2020**
(21) Numéro de dépôt: 16168687.8
(22) Date de dépôt: 09.05.2016
(51) Int. Cl.: G01R 19/25

(54) **MESURE DE VARIATIONS D'UNE TENSION D'ALIMENTATION**
MESSUNG DER SCHWANKUNGEN EINER NETZSPANNUNG
MEASUREMENT OF VARIATIONS OF AN INPUT VOLTAGE

(30) Priorité: 08.06.2015 FR 1555212
(43) Date de publication de la demande: 26.04.2017
(73) Titulaire: STMICROELECTRONICS (ROUSSET) SAS, 13790 Rousset (FR)
(72) Inventeur: BACHER, Yann, 13790 ROUSSET (FR); FROIDEVAUX, Nicolas, 13100 AIX-EN-PROVENCE (FR)
(74) Mandataire: Cabinet Beaumont

(56) Documents cités:
- WO-A1-2007/099079
- FR-A1- 2 719 123
- FR-A1- 2 783 636
- FR-A1- 2 996 309
- US-A1- 2014 184 184

## Description

### Domaine

La présente description concerne de façon générale les circuits électroniques et, plus particulièrement, un circuit de surveillance de la tension d'alimentation d'un circuit intégré.

### Exposé de l'art antérieur

Dans de nombreuses applications, on souhaite surveiller l'évolution de la tension d'alimentation d'un circuit intégré pendant son fonctionnement. En effet, les variations de cette tension d'alimentation peuvent induire des problèmes dans le fonctionnement du circuit et/ou reflètent la consommation du circuit, donc des variations d'activité du circuit et/ou reflètent des comportements du circuit soumis à une contrainte, par exemple une perturbation volontaire (par exemple, une attaque) ou accidentelle (par exemple, une décharge électrostatique).

La mesure de la tension d'alimentation s'effectue, par exemple pour des besoins de test, à l'aide de pointes appliquées à différents endroits du circuit et reliées à un appareil de mesure. La mesure est alors particulièrement sensible à des perturbations électromagnétiques engendrées par l'utilisation de pointes conductrices. De plus, une telle mesure est incompatible avec une mesure en temps réel lors du fonctionnement du circuit dans son environnement applicatif.

On a déjà proposé des solutions internes à un circuit pour mesurer les variations de sa tension d'alimentation. Toutefois, ces solutions ne permettent pas de mesurer des variations non périodiques et la précision des mesures dépend de la valeur de la tension d'alimentation elle-même, ces circuits internes étant sensibles aux perturbations de l'alimentation qui, le plus souvent est externe au circuit. Par ailleurs, de telles mesures ne permettent pas de mesurer des tensions supérieures à la tension supportée par la technologie.

Le document FR 2966309 décrit un circuit de mesure d'une tension au moyen d'un convertisseur statique et prévoit de déterminer une valeur mesurée à partir de la valeur de la tension de sortie du convertisseur de tension, cette tension de sortie étant elle-même asservie à une image de la tension d'entrée.

Le document FR 2719123 décrit un dispositif de détection de variations non transitoires d'une tension d'alimentation sans conversion analogique-numérique.

Le document FR 2783636 décrit un système pour indiquer l'état d'une batterie de véhicule et compare une tension d'alimentation à une tension de référence.

Le document US2014/184184 décrit un circuit de détection de tension.

### Résumé

Le mode de réalisation selon la revendication 1 pallie tout ou partie des inconvénients des circuits usuels de mesure de la tension d'alimentation d'un circuit intégré.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de façon schématique, un mode de réalisation d'un circuit de mesure de variations de la tension d'alimentation d'un circuit intégré ;
la figure 2 illustre un mode de réalisation simplifié d'un écrêteur du circuit de mesure de la figure 1 ;
la figure 3 est un exemple de réalisation d'un convertisseur équipant le circuit de mesure de la figure 1 ;
la figure 4 est un graphe représentant un exemple de variation de la tension VDD et illustrant le comportement statique du circuit de la figure 3 ; et
la figure 5 est un chronogramme représentant des exemples de variation de la tension VDD et illustrant le comportement dynamique du circuit de la figure 3.

### Description détaillée

De mêmes éléments ont été désignés par de mêmes références aux différentes figures. En particulier, les éléments structurels et/ou fonctionnels communs aux différents modes de réalisation peuvent présenter les mêmes références et peuvent disposer de propriétés structurelles, dimensionnelles et matérielles identiques. Par souci de clarté, seuls les éléments utiles à la compréhension des modes de réalisation décrits ont été représentés et seront détaillés. En particulier, les éléments présents dans le circuit intégré dont on surveille la tension d'alimentation n'ont pas été détaillés, les modes de réalisation décrits étant compatibles avec les applications usuelles. Lorsque l'on fait référence aux termes "environ", "approximativement" ou "de l'ordre de", cela signifie à 10 % près, de préférence à 5 % près.

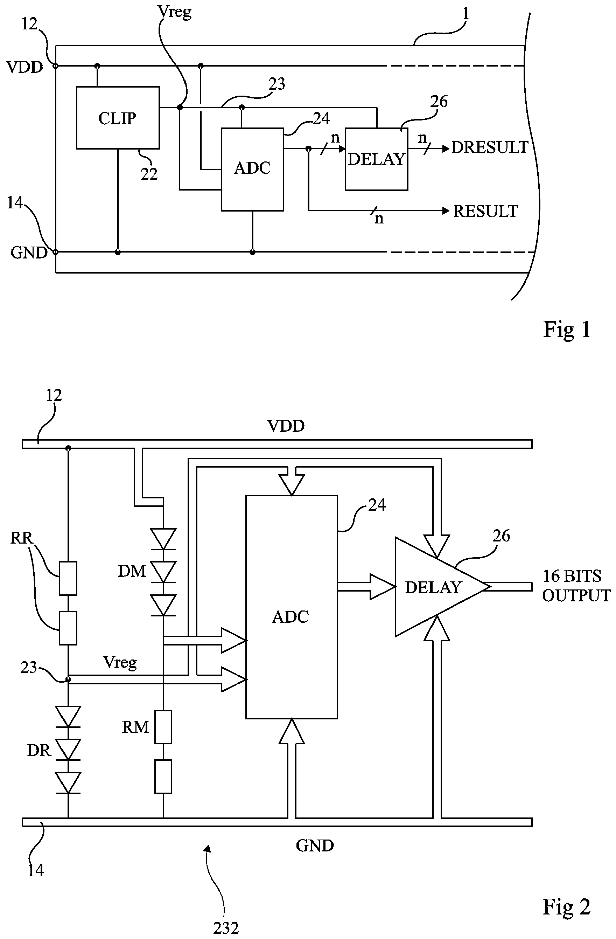

La figure 1 représente, de façon schématique, un mode de réalisation d'un circuit de mesure de variations de la tension d'alimentation d'un circuit électronique.

Le circuit électronique 1 n'est représenté que partiellement avec les éléments qui constituent le circuit de mesure interne des variations de sa tension d'alimentation. Le reste du circuit 1 dépend de l'application.

Le circuit 1 est alimenté par une tension VDD appliquée entre une borne 12 d'application d'un potentiel VDD et une borne 14 définissant un potentiel de référence, typiquement la masse GND. La tension VDD constitue la tension d'alimentation dont on souhaite surveiller l'évolution ou les variations.

Selon les modes de réalisation décrits, on prévoit un limiteur de tension 22 (CLIP) rapide, c'est-à-dire ayant une faible constante de temps par rapport à la durée des variations à mesurer. Plus précisément, les applications visées par la présente description requérant la détection de pics dans la tension d'alimentation, le limiteur n'a pas pour objectif de lisser la tension Vreg qu'il fournit en sortie 23, mais de limiter l'excursion de la tension qu'il fournit, c'est-à-dire de faire en sorte que cette tension soit écrêtée.

La tension Vreg sert à alimenter un convertisseur analogique numérique 24 (ADC) dont une entrée (de conversion) reçoit une tension proportionnelle à la tension VDD à mesurer. La tension Vreg sert également de référence pour générer les tensions de mesure du convertisseur 24. Le convertisseur 24 fournit, en sortie, un mot numérique RESULT sur n bits représentatif de la valeur instantanée de la tension mesurée. Ce résultat peut être interprété directement.

Les bits de sortie RESULT traversent également un circuit retardateur (DELAY) 26 (lignes à retard). Le circuit retardateur fournit un signal DRESULT qui permet de différer la prise en compte de la mesure par le reste du circuit ou par un appareil externe. En présence d'une perturbation, il y a un fort risque que le circuit ou l'appareil lisant le résultat soit lui-même perturbé. Différer la prise en compte de la mesure permet de s'affranchir de ce risque et de fournir une mesure fiable. En effet, le signal DRESULT contient la perturbation mais cette perturbation a disparu lorsque ce signal est fourni. Par conséquent, le circuit d'interprétation des mesures, qu'il soit interne ou externe, peut déterminer la perturbation.

La figure 2 représente un mode de réalisation du limiteur 22 de la figure 1 et un circuit 232 d'adaptation du niveau de mesure du convertisseur 23. Dans l'exemple de la figure 2, le circuit retardateur 26 fournit un signal numérique sur 16 bits (16 BITS OUTPUT).

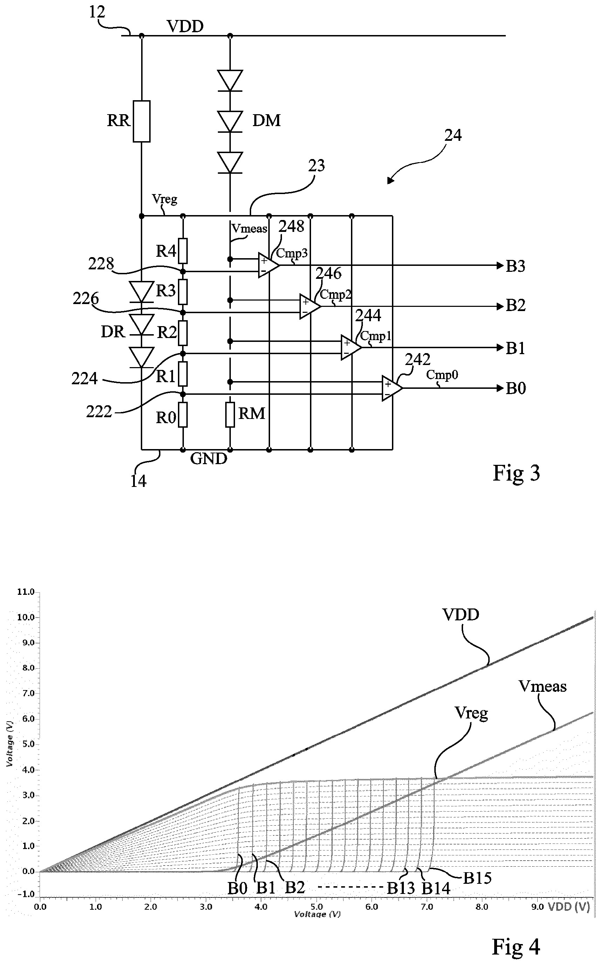

La figure 3 représente un schéma plus détaillé, illustrant un exemple de réalisation du convertisseur 24, associé à un limiteur de tension et une adaptation d'impédance.

Le régulateur 22 est ici constitué d'une ou plusieurs résistances RR en série avec une ou plusieurs diodes (par exemple, trois) DR, les diodes étant orientées, cathode vers la borne 14. Le point milieu 23 entre les résistances RR et les diodes DR fournit la tension écrêtée Vreg. Cette tension Vreg varie donc entre la masse (au démarrage du circuit, le temps que la tension VDD croisse) et un niveau maximal fixé par la somme des chutes de tension en direct dans les diodes DR. Dans l'exemple de la figure 3, une seule résistance RR est symbolisée au lieu de deux en figure 2.

Côté convertisseur 24, la tension Vreg est utilisée comme référence de mesure pour les différents poids des bits du convertisseur. Ainsi, en supposant comme en figure 3, un convertisseur sur 4 bits, quatre comparateurs 242 (Cmp0), 244 (Cmp1), 246 (Cmp2) et 248 (Cmp3) fournissent les 4 états B0, B1, B2, B3 du mot binaire. Les entrées de référence (par exemple inverseuses) des comparateurs 242, 244, 246 et 248 sont respectivement connectées à des noeuds 222, 224, 226, 228 d'une association en série de résistances R0, R1, R2, R3, R4, entre la borne 23 et la masse 14. Les deuxièmes entrées des comparateurs 242, 244, 246 et 248 (par exemple non inverseuses) reçoivent une information Vmeas proportionnelle à la tension VDD. Par exemple, ces entrées sont connectées au point milieu d'une association en série d'un ensemble de diodes DM et d'une ou plusieurs résistances RM. De préférence, le nombre de diodes DR est inférieur ou égal au nombre de diodes DM. Par exemple, le nombre de diodes DM correspond au nombre de diodes DR et la valeur de la résistance RM (ou la valeur cumulée des résistances en série RM) correspond approximativement à la valeur de la résistance RR. Ainsi, le convertisseur commence à mesurer des variations de la tension VDD une fois que celle-ci a atteint au moins la valeur Vreg fixée par les diodes DR en série.

La figure 4 est un graphe représentant un exemple de variation de la tension VDD et illustrant le comportement statique du circuit de la figure 3.

La figure 4 illustre, sur des échelles de tension en volts (Voltage (V)), un exemple de croissance de la tension VDD, depuis une valeur nulle, l'évolution correspondante de la tension Vreg, de la tension Vmeas et des sorties binaires 0 à 15 (B0 à B15) du convertisseur 24. Dans l'exemple de la figure 4, on suppose un convertisseur 24 sur 16 bits.

Tant que la tension VDD n'a pas atteint la valeur Vreg, tous les bits B0 à B15 sont à l'état 0. Quand la tension VDD atteint le niveau Vreg, le bit B0 commute à l'état 1. En supposant, comme en figure 4, une croissance linéaire de la tension VDD, les bits B1 à B15 commutent les uns après les autres jusqu'à ce que la tension Vmeas atteigne (approximativement) la tension Vreg.

La sortie RESULT du convertisseur 24 fournit donc une valeur binaire fonction de la tension VDD. La sortie DRESULT fournit le même mot binaire, mais retardé.

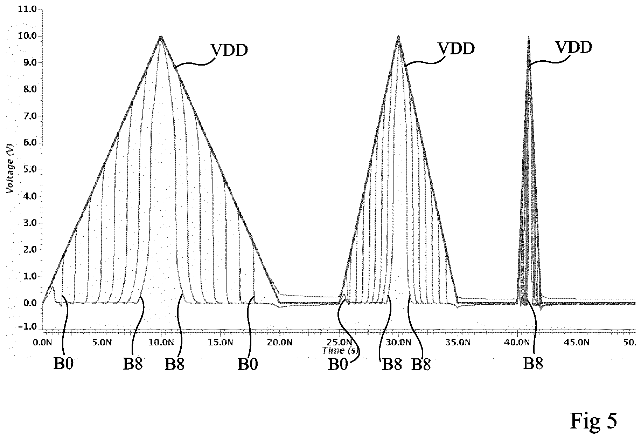

La figure 5 est un graphe représentant des exemples variation de la tension VDD en volts (Voltage (V)) et illustrant le comportement dynamique du circuit de la figure 3.

La figure 5 illustre trois exemples de pics de la tension VDD plus ou moins rapides par rapport à la tension Vreg et les commutations correspondantes des bits du convertisseur 24. Dans l'exemple de la figure 5, on suppose un convertisseur 24 sur 8 bits. On suppose trois pics de même amplitude mais de durées différentes sur une échelle temporelle (Time (s)) en nanosecondes (N) .

Comme l'illustre la figure 5, la rapidité des pics se traduit par une commutation plus ou moins rapide des sorties du convertisseur. Plus le pic est rapide, plus les sorties commutent de façon rapprochée. De même, plus le pic est rapide, plus les bits reviennent rapidement à l'état de repos.

Le fait de disposer d'une sortie numérique (sur plusieurs bits) permet de mémoriser aisément le résultat de la mesure. La fréquence de mémorisation des valeurs obtenues dépend de l'application et ne dépend pas de la mesure elle-même.

Un avantage des réalisations décrites est qu'il est désormais possible d'évaluer les variations de la tension d'alimentation d'un circuit intégré au cours du temps en s'affranchissant des éventuelles perturbations électromagnétiques. On peut ainsi distinguer une variation rapide d'une variation lente de la tension d'alimentation.

Un autre avantage des réalisations décrites est que la mesure s'effectuant de façon différentielle par rapport à la tension Vreg, elle devient indépendante de la valeur de la tension VDD.

Un autre avantage des réalisations décrites est que, grâce à une mesure intégrée au circuit lui-même, on enrichit l'éventail d'applications disponibles à une telle mesure. Par exemple, le circuit de mesure peut être utilisé pour détecter d'éventuelles attaques d'un circuit intégré par modification de sa tension d'alimentation ou pour détecter une perturbation extérieure de type décharge électrostatique. Le circuit intégré peut alors prendre les mesures protectrices nécessaires.

Divers modes de réalisation ont été décrits. Diverses variantes et modifications apparaîtront à l'homme de l'art. En particulier, le nombre de bits du convertisseur dépend de l'application et de la précision souhaitée dans l'évaluation de la valeur de tension. Par ailleurs, on peut également adapter la vitesse de conversion en fonction du comportement que l'on souhaite mesurer. De plus, le choix des seuils de détection dépend également de l'application. Selon une autre variante, le circuit est adapté pour mesurer des pics de tension négatifs. Enfin, la mise en oeuvre pratique des modes de réalisation qui ont été décrits est à la portée de l'homme du métier à partir des indications fonctionnelles données ci-dessus.

## Revendications

1. Circuit de mesure de variations d'une tension d'alimentation (VDD) d'un circuit électronique (1) entre une première borne (12) d'application d'un potentiel d'alimentation VDD et une deuxième borne (14) définissant un potentiel de référence, comportant :
un régulateur (22) comportant une ou plusieurs résistances (RR) en série avec une ou plusieurs diodes (DR) entre les première et deuxième bornes, les diodes étant orientées, cathode vers la deuxième borne; et le point milieu (23) entre résistances et diodes fournissant une valeur de référence (Vreg) correspondant à une valeur écrêtée de la tension d'alimentation ; et
un convertisseur analogique-numérique (24) d'une différence entre une valeur (Vmeas) proportionnelle à la tension d'alimentation et ladite valeur de référence (Vreg), des sorties du convertisseur analogique-numérique fournissent au moins un premier signal constituant un premier résultat (RESULT) indicateur de variations de la tension d'alimentation, le premier signal étant en outre traité par au moins un élément retardateur (26) dont une sortie fournit un deuxième résultat (DRESULT).

## Patentansprüche

1. Schaltung zum Messen von Änderungen einer Stromversorgungsspannung (VDD) einer elektronischen Schaltung (1) zwischen einem ersten Anschluss (12) zum Anlegen eines Versorgungsspannung VDD und einem zweiten Anschluss (14), der eine Bezugsspannung definiert, aufweisend:
einen Regler (22) mit einem oder mehreren Widerständen (RR) in Reihe mit einer oder mehreren Dioden (DR) zwischen dem ersten und dem zweiten Anschluss, wobei die Dioden mit ihrer Kathode zum zweiten Anschluss hin ausgerichtet sind; und wobei der Mittelpunkt (23) zwischen den Widerständen und den Dioden einen Referenzwert (Vreg) liefert, der einem Grenzwert der Versorgungsspannung entspricht; und
einen Analog-Digital-Wandler (24) einer Differenz zwischen einem Wert (Vmeas), der proportional zur Versorgungsspannung ist, und dem Referenzwert (Vreg), wobei Ausgänge des Analog-Digital-Wandlers wenigstens ein erstes Signal vorsehen, das ein erstes Ergebnis (RESULT) bildet, das repräsentativ für Änderungen der Versorgungsspannung ist, wobei das erste Signal durch wenigstens ein Verzögerungselement (26) mit einem Ausgang, der ein zweites Ergebnis (DRESULT) liefert, weiterverarbeitet wird, das.

## Claims

1. A circuit for measuring variations of a power supply voltage (VDD) of an electronic circuit (1), between a first terminal (12) of application of a supply potential VDD and a second terminal (14) defining a reference potential, comprising :
a regulator (22) comprising one or several resistors (RR) in series with one or several diodes (DR) between the first and second terminals, the diodes being oriented with their cathode towards the second terminal ; and the mid-point (23) between the resistors and the diodes providing a reference value (Vreg) correspond to a clipped value of the power supply voltage ; and
an analog-to-digital converter (24) of a difference between a value (Vmeas) proportional to the power supply voltage and said reference value (Vreg), outputs of the analog-to-digital converter provide at least one first signal constituting a first result (RESULT) representative of variations of the power supply voltage, the first signal being further processed by at least one delay element (26) having an output providing a second result (DRESULT).
